(19) Europäisches Patentamt
European Patent Office
Office européen des brevets

(11) **EP 4 589 314 A1**

(12) **EUROPEAN PATENT APPLICATION**
published in accordance with Art. 153(4) EPC

(43) Date of publication:
**23.07.2025  Bulletin 2025/30**

(51) International Patent Classification (IPC):
***G01R 31/34*** *(2020.01)*    ***G01R 31/12*** *(2020.01)*

(21) Application number: **22958751.4**

(52) Cooperative Patent Classification (CPC):
**G01R 31/12; G01R 31/34**

(22) Date of filing: **13.09.2022**

(86) International application number:
**PCT/JP2022/034278**

(87) International publication number:
**WO 2024/057418 (21.03.2024 Gazette 2024/12)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Nissin Pulse Electronics Co., Ltd.
Noda-shi, Chiba 278-0022 (JP)**

(72) Inventors:
• **SATO Hisato
Noda-shi, Chiba 278-0022 (JP)**
• **WANG Qiang
Noda-shi, Chiba 278-0022 (JP)**

(74) Representative: **Becker, Eberhard
Becker Kurig & Partner
Patentanwälte mbB
Bavariastraße 7
80336 München (DE)**

(54)    **INVERTER PULSE INSULATION TEST DEVICE**

(57)    The present invention provides an inverter pulse insulation test device comprising a pulse generation circuit and a surge voltage generation circuit. The pulse generation circuit outputs a voltage having a simulated drive voltage waveform that includes intermittent pulses. The surge voltage generation circuit generates a surge voltage at each of a rise and a fall of each pulse of the drive voltage waveform to change the drive voltage waveform and outputs a voltage having the changed drive voltage waveform. The surge voltage generation circuit has: a variable resistor and a variable inductor connected in series to each other; and a variable capacitor.

FIG. 1

## Description

Technical Field

The disclosure relates to an inverter pulse insulation test device.

Related Art

Patent Document 1 discloses an insulation inspection device and an insulation inspection method of an inverter-driven motor. Patent Document 2 discloses an inverter-driven rotary electric machine (specifically, an inverter-driven rotary electric machine having a rated voltage of 700 rms or lower) and a phase-to-phase insulation partial discharge inspection method and a phase-to-phase insulation partial discharge inspection apparatus of the rotary electric machine. Patent Document 3 discloses a method capable of realizing a discharge resistance test of the windings of a multi-channel frequency-variable motor. Patent Document 4 discloses a method for a discharge resistance test for the windings of an inverter-driven motor.

Citation List

Patent Literature

Patent Document 1: WO 2014/083866
Patent Document 2: WO 2012/147163
Patent Document 3: Specification of Chinese Patent No. 106226663
Patent Document 4: Specification of Chinese Utility Model Patent No. 204439681

SUMMARY OF INVENTION

Technical Problem

In recent years, from the viewpoint of energy saving, variable speed driving of electric motors using inverters has become popular. For example, in the automobile industry, from the viewpoint of global warming and environmental issues, reducing $CO_2$ emission has been an issue. Therefore, the transformation from driving with conventional engines to driving with inverter motors, that is, the transformation from vehicles using gasoline and diesel to electric vehicles (EV), hybrid electric vehicles (HEV), and plug-in hybrid vehicles (PHEV), and fuel cell vehicles (FCV) is underway. In addition, the motor drive voltage has been increasing (e.g., 600V or higher) as the main objective of increasing the motor output. Such tendency is not limited to the automobile industry, but also common in other industries.

In the control of inverter-driven motors, pulse control methods such as pulse width modulation (PWM) control methods have been widely adopted. In the pulse control methods, voltage pulses are generated through high-speed switching of power devices. However, due to the inductance of the wiring from the power device to the motor, a surge voltage is generated at the rise and the fall of the voltage pulse. When the surge voltage is excessively high, a partial discharge occurs in the winding of the motor, and the insulation properties of the resin covering the winding deteriorate. If the thickness of the insulation coating of the winding increases to suppress the partial discharge, the size of the motor increases. In addition, the higher the carrier frequency of the pulse control, the more frequently the partial discharge occurs, and the more quickly the insulation properties deteriorate. Accordingly, it is desired to accurately test and evaluate the deterioration level of the insulation member, such as the insulation coating, of the winding due to the surge voltage included in the voltage pulse.

An objective of the disclosure is to provide an inverter pulse insulation test device capable of accurately testing and evaluating the deterioration level of the insulation member due to the surge voltage included in the voltage pulse.

Solution to Problem

An aspect of the disclosure provides an inverter pulse insulation test device. The inverter pulse insulation test device includes a pulse generation circuit and a surge voltage generation circuit. The pulse generation circuit has a first output end, and outputs, from the first output end, a voltage having a simulated drive voltage waveform including intermittent pulses. The surge voltage generation circuit has an input end electrically connected to the first output end of the pulse generation circuit and a second output end connected to a test object. The surge voltage generation circuit changes the drive voltage waveform by generating a surge voltage at a rise and a fall of each pulse of the drive voltage waveform input from the input end, and outputs, from the second output end, a voltage having the drive voltage wave form that is changed. The surge voltage generation circuit has: a variable resistor and a variable inductor connected in series to each other; and a variable capacitor. An end of a serial circuit of the variable resistor and the variable inductor form the input end of the surge voltage generation circuit. An other end of the serial circuit is connected to the second output end of the surge voltage generation circuit. An end of the capacitance variable capacitor is connected to a node between the other end of the serial circuit and the second output end. An other end of the capacitance variable capacitor is connected to a constant potential line.

According to the device, the deterioration level of the insulation member can be accurately tested according to the surge voltage included in the voltage pulse.

In the above device, it may also be that the pulse generation circuit outputs a voltage having a two-level or three-level inverter drive waveform as the drive voltage waveform. The pulse generation circuit may have a first semiconductor switch, a second semiconductor switch, a bridge full-wave rectifier, and a third semiconductor switch. In the first semiconductor switch, an end is connected to a positive voltage terminal, and an other end is connected to the first output end. In the second semiconductor switch, an end is connected to a negative voltage terminal, and an other end is connected to the second output end. The bridge full-wave rectifier has two input ends and two output ends. One of the two input ends is connected to a reference potential line, and one of the two output ends is connected to the first output end. In the third semiconductor switch, an end is connected to an other one of the input ends of the bridge full-wave rectifier and an other end is connected to an other one of the output ends of the bridge full-wave rectifier

In the above device, it may also be that the pulse generation circuit has: multiple semiconductor switches for forming the drive voltage waveform; and a first control part, generating multiple optical trigger signals respectively controlling the semiconductor switches. The first control part provides the respective optical trigger signals to the respective semiconductor switches.

The device may further include a second control part and an input operation part. The second control part controls the drive voltage waveform in the pulse generation circuit. The input operation part receives an input operation relating to a number of the intermittent pulses, and provides information relating to the number of the intermittent pulses input through the input operation to the second control part. The second control part determines the number of the intermittent pulses in accordance with the information.

The device may further include a second control part and an input operation part. The second control part controls the drive voltage waveform in the pulse generation circuit. The input operation part receives an input operation relating to the drive voltage waveform and provides, to the second control part, information relating to the drive voltage waveform input through the input operation. The second control part may determine the drive voltage waveform in accordance with the information. The information relating to the drive voltage waveform includes at least one of: information relating to whether the intermittent pulses are formed by positive pulses only, negative pulses only, or both of the positive pulses and the negative pulses; the information relating to whether the intermittent pulses are permanently output until the test ends or output in bursts within a period set in advance; the information relating to the amplitude of the intermittent pulse; the information relating to the frequency of the intermittent pulses; and the information relating to the time width of each pulse forming the intermittent pulses.

Effects of Invention

According to the disclosure, it is possible to provide an inverter pulse insulation test device capable of accurately testing and evaluating the deterioration level of the insulation coating of the winding due to the surge voltage included in the voltage pulse.

BRIEF DESCRIPTION OF DRAWINGS

[FIG. 1] FIG. 1 is a schematic diagram illustrating a configuration of an inverter pulse insulation test device according to an embodiment.
[FIG. 2] FIG. 2 is a circuit diagram illustrating a configuration example of a pulse generation circuit.
[FIG. 3] FIG. 3 is a circuit diagram illustrating a configuration example of a surge voltage generation circuit.
[FIG. 4] FIG. 4 is a circuit diagram illustrating another configuration example of the surge voltage generation circuit.
[FIG. 5] FIG. 5 is a circuit diagram illustrating yet another configuration example of the surge voltage generation circuit.
[FIG. 6] (a), (b), and (c) of FIG. 6 are diagrams schematically illustrating a voltage pulse of a positive polarity including a surge voltage and output from the surge voltage generation circuit.
[FIG. 7] FIG. 7 is a schematic diagram illustrating an example of a drive voltage waveform of two polarities including the surge voltage.
[FIG. 8] FIG. 8 is a schematic diagram illustrating an example of a drive voltage waveform including the surge voltage.
[FIG. 9] FIG. 9 is a schematic diagram illustrating an example of a drive voltage waveform including the surge voltage.
[FIG. 10] FIG. 10 is a schematic diagram illustrating an example of a drive voltage waveform including the surge voltage.
[FIG. 11] FIG. 11 is a schematic diagram illustrating an example of a drive voltage waveform including the surge voltage.
[FIG. 12] FIG. 12 is a schematic diagram illustrating an example of a drive voltage waveform without a surge voltage.
[FIG. 13] FIG. 13 is a schematic diagram illustrating an example of a drive voltage waveform without a surge voltage.
[FIG. 14] FIG. 14 is a schematic diagram illustrating an example of a drive voltage waveform including the surge voltage.
[FIG. 15] (a) to (e) of FIG. 15 are diagrams illustrating drive voltage waveforms including the surge voltage, which are actually tested in a test device.
[FIG. 16] (a) to (e) of FIG. 16 are diagrams illustrating drive voltage waveforms actually tested in the test device.

[FIG. 17] FIG. 17 is a block diagram illustrating a system configuration example of a test device according to an embodiment.

[FIG. 18] FIG. 18 is a diagram illustrating an example of a two-level PWM drive waveform.

[FIG. 19] FIG. 19 is a diagram illustrating an example of a three-level PWM drive waveform.

[FIG. 20] (a) of FIG. 20 schematically illustrates a rectangular wave before a surge voltage occurs. (b) of FIG. 20 schematically illustrates a rectangular wave after a surge voltage occurs.

DESCRIPTION OF EMBODIMENTS

Specific examples of an inverter pulse insulation test device of the disclosure are described in the following with reference to the drawings. Nevertheless, the invention is not limited to the examples, but is defined by the claims, and is intended to include all modifications within the meaning and scope of the claims. In the following description, the same symbol is assigned to the same component in the description of the drawings, and repeated description is omitted.

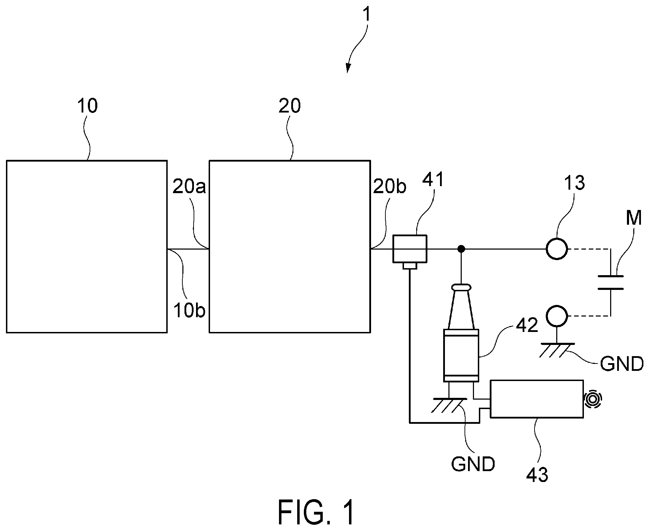

FIG. 1 is a schematic diagram illustrating a configuration of an inverter pulse insulation test device 1 (simply referred to as a test device) according to an embodiment. The test device 1, for example, is used to perform insulation evaluation on an inverter-driven motor and a winding, an insulation coating resin, and an insulation member, etc., used therefor. Alternatively, the test device 1 is used for the insulation evaluation of a magnetic wire, the insulation evaluation of an insulation paint for the surface of a magnetic wire, etc., the insulation evaluation of an electronic component, etc., as well as the service time evaluation and V-t test thereof. As shown in FIG. 1, the test device 1 of the embodiment includes a pulse generation circuit 10 and a surge voltage generation circuit 20.

The pulse generation circuit 10 has an output end (first output end) 10b, and outputs a voltage having a simulated drive voltage waveform that includes intermittent pulses from the output end 10b. The drive voltage waveform, for examples, includes a one-level, two-level, or three-level inverter drive waveform in order to simulate pulse width modulation (PWM) control, for example.

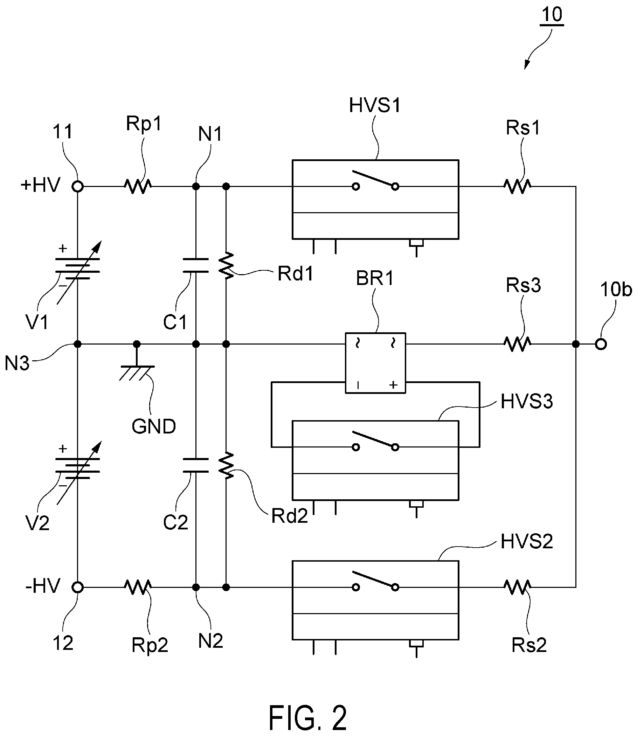

FIG. 2 is a circuit diagram illustrating a configuration example of the pulse generation circuit 10. The pulse generation circuit 10 shown in FIG. 2 includes a positive polarity DC power source V1, a negative polarity DC power source V2, resistors Rp1 and Rp2, capacitors C1 and C2, and discharge resistors Rd1 and Rd2. In addition, the pulse generation circuit 10 has multiple (three in the example as shown) semiconductor switches HVS1, HVS2, HVS3 for forming a drive voltage waveform, and a bridge full-wave rectifier BR1.

The positive polarity DC power source V1 and the negative polarity DC power source V2 form a power source part of the pulse generation circuit 10. The positive polarity DC power source V1 and the negative polarity DC power source V2 are connected to each other in series. A node N3 between The positive polarity DC power source V1 and the negative polarity DC power source V2 is connected to a reference potential line GND and defined as a reference potential (0V). An end on the opposite side of the reference potential of the positive polarity DC power source V1 is arranged as a positive high voltage terminal (+HV) 11. An end on the opposite side of the reference potential of the negative polarity DC power source V2 is arranged as a negative high voltage terminal (-HV) 12. As an example, the absolute value of the potential of the positive high voltage terminal 11 is equal to the absolute value of the potential of the negative high voltage terminal 12.

The capacitors C1 and C2 form an energy accumulation part of the pulse generation circuit 10. The capacitors C1 and C2 are connected to each other in series. A node between the capacitors C1 and C2 are connected to the reference potential line GND and defined as the reference potential (0V). An end on the opposite side of the capacitor C1 is connected to a node N1. The node N1 is connected to the positive high voltage terminal 11 via the resistor Rp1. A n end on the opposite side of the capacitor C2 is connected to a node N2. The node N2 is connected to the negative high voltage terminal 12 via the resistor Rp2. The capacitor C1 accumulates positive polarity energy. The capacitor C2 accumulates negative polarity energy. The smaller the inductive components of the capacitors C1 and C2, the better.

The discharge resistors Rd1 and Rd2 are connected to each other in series. A node between the discharge resistors Rd1 and Rd2 are connected to the reference potential line GND and defined as the reference potential (0V). An end on the opposite side of the discharge resistor Rd1 is connected to the node N1. An end on the opposite side of the discharge resistor Rd2 is connected to the node N2. In other words, the discharge resistor Rd1 and the capacitor C1 are connected in parallel, and the discharge resistor Rd2 and the capacitor C2 are connected in parallel.

The semiconductor switches HVS1, HVS2, and HVS3 form a semiconductor switch part of the pulse generation circuit 10. The semiconductor switches HVS1, HVS2, and HVS3 are electric field effect transistors (FETs) formed by SiC semiconductors, for example. The semiconductor switch S1 is the first semiconductor switch of the embodiment. An end of the semiconductor switch HVS1 is connected to the node N1 and connected to the positive high voltage terminal 11 via the resistor Rp1. The resistor Rp1 is a charge protection resistor. The other end of the semiconductor switch HVS1 is connected to the output end 10b via the resistor RS1 that is a non-inductive protection resistor. The resistor Rs1 protects the semiconductor switch HVS1, so that the output current of the semiconductor switch HVS1 does not exceed a maximum rated current of the semiconductor switch HVS1. The semiconductor switch HVS1 outputs a positive voltage pulse.

The semiconductor switch S2 is the second semiconductor switch of the embodiment. An end of the semiconductor switch HVS2 is connected to the negative high voltage terminal 12 via the resistor Rp2. The resistor Rp2 is a charge protection resistor. The other end of the semiconductor switch HVS2 is connected to the output end 10b via the resistor RS2 that is a non-inductive protection resistor. The resistor Rs2 protects the semiconductor switch HVS2, so that the output current of the semiconductor switch HVS2 does not exceed a maximum rated current of the semiconductor switch HVS2. The semiconductor switch HVS2 outputs a negative voltage pulse. The semiconductor switch HVS2 is controlled so as not to be turned on at the same time with the semiconductor switch HVS1.

The bridge full-wave rectifier BR1 has two input ends and two output ends. One of the two input ends of the bridge full-wave rectifier BR1 is connected to the reference potential line GND and is connected to the node N3 between the positive DC power source V1 and the negative DC power source V2. One of the two output ends of the bridge full-wave rectifier BR1 is connected to the output end 10b via a resistor Rs3 that is a non-inductive protection resistor. The resistor Rs3 protects the semiconductor switch HVS3, so that the output current of the semiconductor switch HVS3 does not exceed a maximum rated current of the semiconductor switch HVS3.

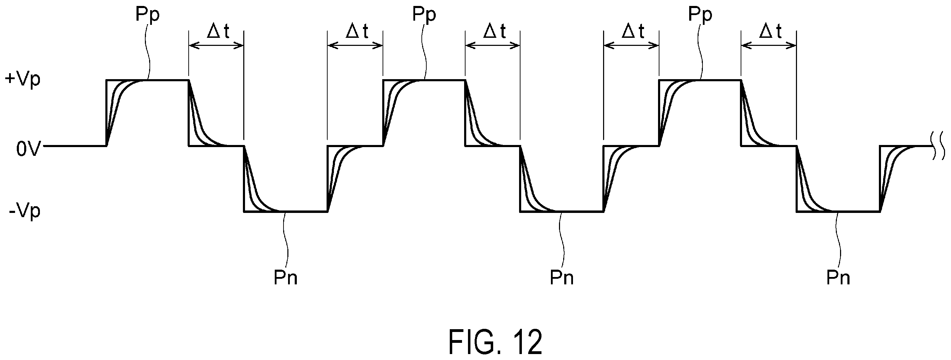

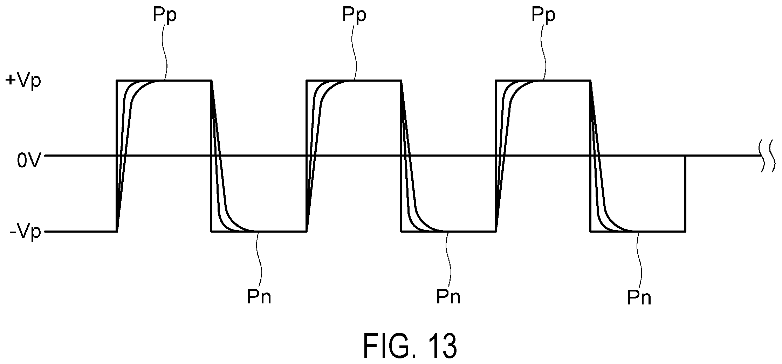

The resistors Rs1, Rs2, and Rs3 form a protection part of the pulse generation circuit 10. With the resistors Rs1, Rs2, and Rs3 being the non-inductive resistors, at the time of outputting a drive voltage waveform without surge voltage (FIGs. 12 and 13), an overshoot voltage generated in the voltage pulse can be suppressed.

The semiconductor switch S3 is the third semiconductor switch of the embodiment. An end of the semiconductor switch HVS3 is connected to the other input end of the bridge full-wave rectifier BR1. The other end of the semiconductor switch HVS3 is connected to the other output end of the bridge full-wave rectifier BR1. The semiconductor switch HVS3 accelerates the time when the positive and negative voltage pulses fall, and the voltage pulses quickly return to the reference potential.

Referring to FIG. 1 again, the surge voltage generation circuit 20 includes an input end 20a electrically connected to the output end 10b of the pulse generation circuit 10 and an output end 20b (second output end) connected to the output terminal 13 of the test device 1. The surge voltage generation circuit 20 is a waveform adjustment part, and resonates and oscillates the drive voltage waveform, which is a rectangular wave input from the input end 20a, by using a RLC circuit. Accordingly, the surge voltage generation circuit generates a surge voltage at the rise and the fall of each voltage pulse of the drive voltage waveform to change the drive voltage waveform and outputs a voltage having the changed drive voltage waveform from the output end 20b. Additionally, the surge voltage generation circuit 20 is able to freely change the resonance condition by making the inductance and capacitance variable.

A current sensor 41 is provided at the wiring between the output terminal 20b of the surge voltage generation circuit 20 and the output terminal 13 of the test device 1. The current sensor 41 measures the magnitude of the current output from the output end 20b. The current sensor 41 is, for example, of a current transformer type, a Hall element type, or a resistor type. A high voltage probe 42 measuring a voltage waveform is connected to a node between the output end 20b of the surge voltage generation circuit 20 and the output terminal 13 of the test device 1. To accurately adjust the drive voltage waveform including the surge voltage, it is desired for the high voltage probe 42 to exhibit high accuracy and high speed. As the high voltage probe 42, for example, a high voltage probe of model number EP-50K (voltage division ratio 1/2000) manufactured by Nissin Pulse Electronics Co., Ltd. may be used. Alternatively, for example, a high voltage probe of model number EP-100K (voltage division ratio 1/5000) manufactured by Nissin Pulse Electronics Co., Ltd. may be used. The current sensor 41 and the high voltage probe 42 form the measurement part of the test device 1. The output signals of the current sensor 41 and the high voltage probe 42 are provided to an oscilloscope 43 and displayed in real-time.

A test object M is connected between the output terminal 13 of the test device 1 and the reference potential line GND. In FIG. 1, the test object M is schematically represented by a capacitance symbol. The test object M is a coating resin included in a motor winding, for example.

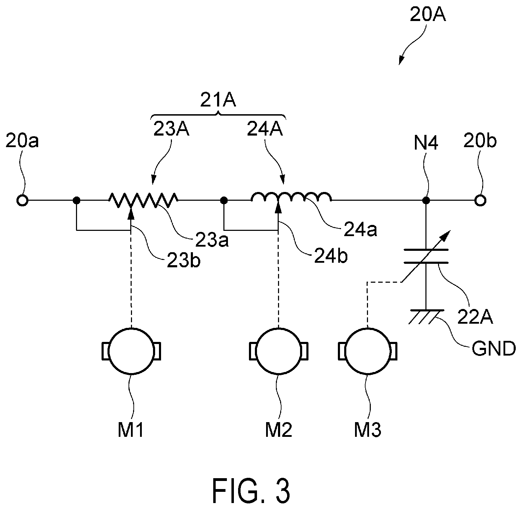

FIG. 3 is a circuit diagram illustrating a surge voltage generation circuit 20A as a configuration example of the surge voltage generation circuit 20. The surge voltage generation circuit 20A shown in FIG. 3 has a serial circuit 21A and a capacitance variable capacitor part 22A. The serial circuit 21A includes a variable resistance part 23A and a variable inductance part 24A connected in series with each other. An end of the serial circuit 21A forms the input end 20a of the surge voltage generation circuit 20A. The other end of the serial circuit 21A is connected to the output end 20b of the surge voltage generation circuit 20A. In the serial circuit 21A, the order between the variable resistance part 23A and the variable inductance part 24A is not limited. That is, the variable inductance part 24A may be connected between the variable resistance part 23A and the input end 20a, or the variable resistance part 23A may also be connected between the variable inductance part 24A and the input end 20a. An end of the capacitance variable capacitor part 22A is connected to a node N4 between the other end of the serial circuit 20A and the output end 20b. The other end of the capacitance variable capacitor part 22A is connected to a constant potential line (e.g., a reference potential line GND).

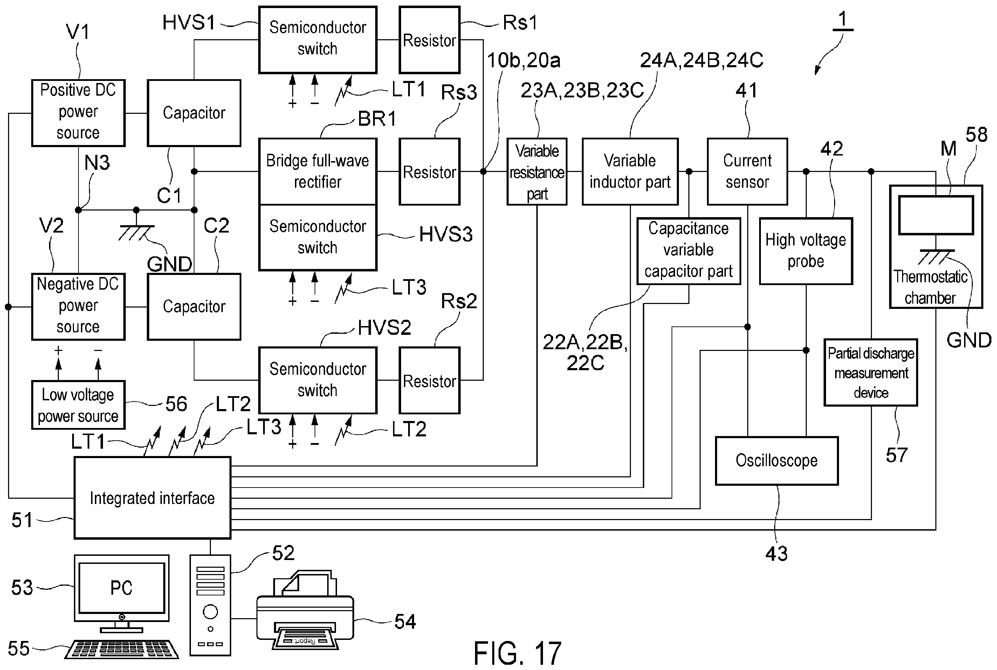

As an example, the resistance value of the variable resistance part 23A is controlled by a motor M1. Specifically, with the motor M1 moving a slider 23b contacting a resistor 23a of the variable resistance part 23A, the contact position of the slider 23b with respect to the resistor 23a is controlled. The contact position of the slider 23b is detected by a sensor. The relationship between the contact position of the slider 23b and the resistance value of the variable resistance part 23A is prepared in advance, and, based on such relationship and the detection result obtained by the sensor, the contact position of the slider 23b is controlled, so that the desired resistance value is achieved. The motor M1 is controlled by a computer 52 (see FIG. 17) to be described afterwards. Alternatively, the resistance value of the variable resistance part 23A may also be adjusted manually.

Similarly, the inductance of the variable inductance part 24A is controlled by a motor M2. Specifically, with the motor M2 moving a slider 24b contacting an inductor 24a of the variable inductance part 24A, the contact position of the slider 24b with respect to the inductor 24a is controlled. The contact position of the slider 24b is detected by a sensor. The relationship between the contact position of the slider 24b and the inductance of the variable inductance part 24A is prepared in advance, and, based on such relationship and the detection result obtained by the sensor, the contact position of the slider 24b is controlled, so that the desired inductance is achieved. The motor M2 is controlled by the computer 52 (see FIG. 17) to be described afterwards. Alternatively, the inductance of the variable inductor part 24A may also be adjusted manually.

The capacitance variable capacitor 22A serves as a parallel resonance capacitor. The capacitance value of the capacitance variable capacitor 22A is controlled by a motor M3. The capacitance value of the capacitance variable capacitor 22A is detected by a sensor, and the capacitance value of the capacitance variable capacitor 22A is controlled, so as to achieve a desired value. The capacitance value of the capacitance variable capacitor 22A is controlled by the computer 52 (see FIG. 17) to be described afterwards. Alternatively, the capacitance value of the capacitance variable capacitor 22A may also be adjusted manually.

The configuration of the variable inductor part 24A is not limited to the type of contact movement using the slider 24b as described above. For example, the variable inductor part 24A may also be of another type, such as inserting a magnetic body or non-magnetic body movable in an air-core coil. In the type of inserting a movable magnetic body or non-magnetic body into an air-core coil, the inductance varies in accordance with the depth of the insertion of the magnetic or non-magnetic body into the air-core coil.

The minimum resistance value of the variable resistance part 23A is 0Ω, and the maximum resistance value of the variable resistance part 23A is within a range of 40Ω to 1kΩ, for example. In the variable resistance part 23A, it is possible to adjust the resistance value steplessly in such range. The minimum inductance of the variable inductor part 24A is 0H, and the maximum inductance of the variable inductor part 24A is within a range of 200 $\mu$H to 500 $\mu$H, for example. In the variable inductor part 24A, it is possible to adjust the resistance value steplessly in such range. The maximum capacitance value of the capacitance variable capacitor 22A is, for example, within a range of 1 nF to 10 nF. The capacitance variable capacitor 22A may be omitted (i.e., the capacitance may be 0) if the capacitance of the test object M is large.

According to the surge voltage generation circuit 20A, the resistance value, the inductance, and the capacitance can be varied continuously, and the drive voltage waveform can be fine-tuned. Additionally, according to the surge voltage generation circuit 20, it is possible to automatically control the resistance value, the inductance, and the capacitance value.

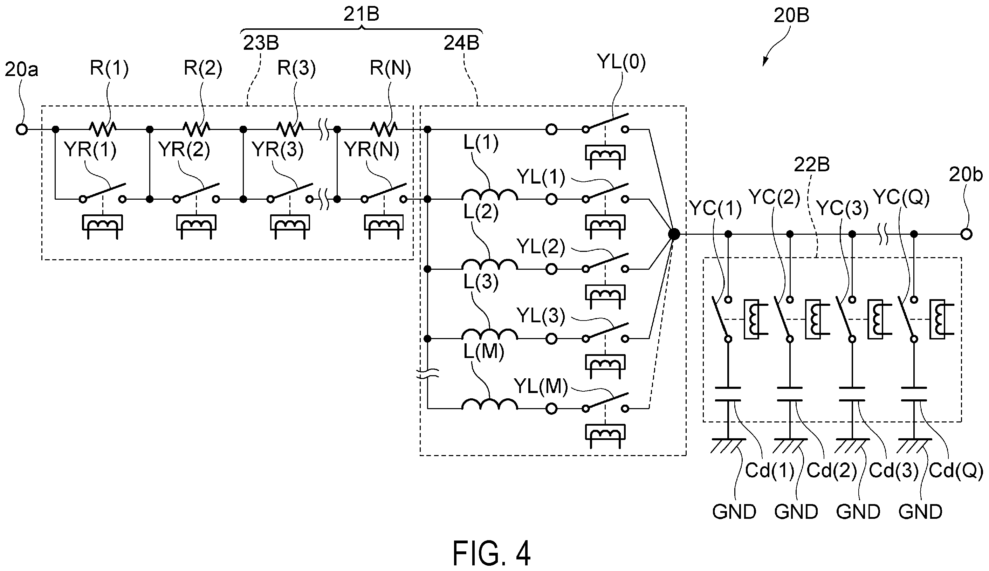

FIG. 4 is a circuit diagram illustrating a surge voltage generation circuit 20B as another configuration example of the surge voltage generation circuit 20. The surge voltage generation circuit 20B shown in FIG. 4 has a serial circuit 21B and a capacitance variable capacitor part 22B. The serial circuit 21B includes a variable resistance part 23B and a variable inductance part 24B connected in series with each other. An end of the serial circuit 21B forms the input end 20a of the surge voltage generation circuit 20B. The other end of the serial circuit 21B is connected to the output end 20b of the surge voltage generation circuit 20B. In the serial circuit 21B, the order between the variable resistance part 23B and the variable inductance part 24B is not limited. That is, the variable inductance part 24A may be connected between the variable resistance part 23B and the input end 20a, or the variable resistance part 23B may also be connected between the variable inductance part 24B and the input end 20a. An end of the capacitance variable capacitor part 22B is connected to a node between the other end of the serial circuit 20B and the output end 20b. The other end of the capacitance variable capacitor part 22B is connected to a constant potential line (e.g., the reference potential line GND).

The variable resistance part 23B includes N resistors R(1) to R(N) that are non-inductive fixed resistors connected with each other in series and N switch YR(1) to YR(N) connected in parallel with the N resistors R(1) to R(N), respectively. N is an integer of 2 or more. With the $n^{th}$ switch YR(n) (n being an integer of 1 or more and N or less) being turned on, the corresponding resistor R(n) is bypassed. The resistance value of the variable resistance part 23B is determined in accordance with the combination of the switches that are turned on among the switches YR(1) to YR(N). The switches YR(1) to YR(N) are electromagnetic relays, for example.

The variable inductance part 24B includes M inductors L(1) to L(M) and (M+1) switches YL(0) to YL(M). M is an integer of 2 or more. The inductances of the inductors L(1) to L(M) are fixed values. An end of the switch YL(0) is connected to the variable resistance part 23B. The other end of the switch YL(0) is connected to the output end 20b. The respective inductors L(1) to L(M) are connected in series with the switches YL(1) to YL(M), respectively. In addition, the M serial circuits including the respective inductors L and the respective switches YL are connected with each other in parallel between the variable resistance part 23B and the output end 20b. In the example as illustrated, the respective inductors L(1) to L(M) are connected between the respective switches YL(1) to YL(M) and the variable resistance part 23B. However, the respective switches YL(1) to YL(M) may also be connected between the respective inductors L(1) to L(M) and the variable resistance part 23B. With the $m^{th}$ switch YR(m) (m being an integer of 1 or more and M or less) being turned on, the corresponding inductor L(n) becomes effective. The inductance of the variable inductor part 23B is determined in accordance with the combination of the switches that are turned on among the switches YL(1) to YL(m). With the $0^{th}$ switch YL(0) being turned on, the inductance of the variable inductor part 24B can be set zero. The switches YL(0) to YL(M) are electromagnetic relays, for example.

The capacitance variable capacitor 22B serves as a parallel resonance capacitor. The capacitance variable capacitor part 22B includes Q capacitors Cd(1) to Cd(Q) and Q switches YC(1) to YC(Q). Q is an integer of 2 or more. The capacitance values of the capacitors Cd(1) to Cd(Q) are fixed values. The respective capacitors Cd(1) to Cd(Q) are connected in series with the switches YC(1) to YC(Q), respectively. In addition, the Q serial circuits including the respective capacitors Cd and the respective switches YC are connected with each other in parallel between the node between the variable inductor part 24B and the output end 20b and the reference potential line GND. In the example as illustrated, the respective capacitors Cd(1) to Cd(Q) are connected between the respective switches YC(1) to YC(Q) and the reference potential line GND. However, the respective switches YC(1) to YC(Q) may also be connected between the respective capacitors Cd(1) to Cd(Q) and the reference potential line GND. With the $q^{th}$ switch YC(q) (q being an integer of 1 or more and Q or less) being turned on, the corresponding capacitor Cd(q) becomes effective. The capacitance value of the capacitance variable capacitor part 22B is determined in accordance with the combination of the switches that are turned on among the switches YC(1) to YC(Q). The switches YC(1) to YC(Q) are electromagnetic relays, for example.

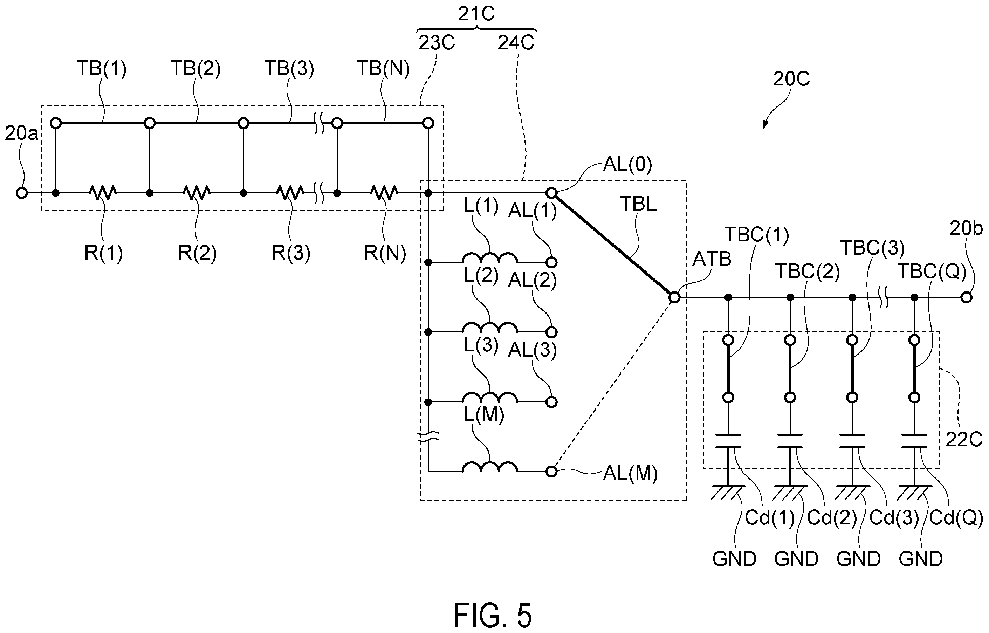

FIG. 5 is a circuit diagram illustrating a surge voltage generation circuit 20C as yet another configuration example of the surge voltage generation circuit 20. The surge voltage generation circuit 20B shown in FIG. 5 has a serial circuit 21C and a capacitance variable capacitor part 22B. The serial circuit 21C includes a variable resistance part 23B and a variable inductance part 24B connected in series with each other. An end of the serial circuit 21C forms the input end 20a of the surge voltage generation circuit 20C. The other end of the serial circuit 21C is connected to the output end 20b of the surge voltage generation circuit 20C. In the serial circuit 21C, the order between the variable resistance part 23C and the variable inductance part 24C is not limited. That is, the variable inductance part 24C may be connected between the variable resistance part 23C and the input end 20a, or the variable resistance part 23C may also be connected between the variable inductance part 24C and the input end 20a. An end of the capacitance variable capacitor part 22C is connected to a node between the other end of the serial circuit 20B and the output end 20b. The other end of the capacitance variable capacitor part 22B is connected to a constant potential line (e.g., the reference potential line GND).

The variable resistance part 23C includes N resistors R(1) to R(N) connected with each other in series and N busbars TB(1) to TB(N) respectively detachably connected in parallel with N resistors R(1) to R(N). The busbars TB(1) to TB(N) are made of copper, for example. Except for the point that the switches YR(1) to YR(N) are respectively replaced with the busbars TB(1) to TB(N), the configuration of the variable resistance part 23C is the same as the configuration of the variable resistance part 23B. By attaching the $n^{th}$ busbar TB(n), the corresponding resistor R(n) is bypassed. The resistance value of the variable resistance part 23C is determined in accordance with the combination of the attached busbars among the busbars TB(1) to TB(N).

The variable inductor part 24C includes M inductors L(1) to L(M) and a detachable busbar TBL. The busbar TBL is made of copper, for example. The inductances of the inductors L(1) to L(M) are fixed values differing from each other. An end of each of the inductors L(1) to L(M) is connected to the variable resistance part 23C. The other end of each of the inductors L(1) to L(M) is connected with an end of the busbar TBL and each of the connectible terminals AL(1) to AL(M). The variable inductance part 24C further includes a terminal AL(0) connectible with an end of the busbar TBL and a terminal ATB connectible to the other end of the busbar TBL. The terminal AL(0) is connected to the variable resistance part 23C without going through the inductor. The terminal ATB is connected to the output end 20b. In the example as illustrated, the respective inductors L(1) to L(M) are respectively disposed between the variable resistance part 23C and the circuit elements respectively including the busbar TBL and the terminals AL(1) to AL(M). However, the circuit elements respectively including the busbar TBL and the terminals AL(1) to AL(M) may also be disposed between the respective inductors L(1) to L(M) and the variable resistance part 23C. With an end of the busbar TBL being connected to the $m^{th}$ terminal AL(m), the corresponding inductor L(m) becomes effective. The inductance of the inductor L(m) selected by the busbar TBL becomes the inductance of the variable inductor part 24C.

The capacitance variable capacitor 22C serves as a parallel resonance capacitor. The capacitance variable capacitor part 22C includes Q capacitors Cd(1) to Cd(Q) and Q detachable busbars TBC(1) to TBC(Q). The capacitance values of the capacitors Cd(1) to Cd(Q) are fixed values. The respective capacitors Cd(1) to Cd(Q) are connected in series with the busbars TBC(1) to TBC(Q). In addition, the Q serial circuits including the respective capacitors Cd and the respective busbars TBC are connected in parallel with each other between the node between the variable inductor part 24C and the output end 20b and the reference potential line GND. In the example as illustrated, the respective capacitors Cd(1) to Cd(Q) are connected between the respective busbars TBC(1) to TBC(Q) and the reference potential line GND. However, the respective busbars TBC(1) to TBC(Q) may also be connected between the respective capacitors Cd(1) to Cd(Q) and the reference potential line GND. By providing the q$^{th}$ busbar TBC(q), the corresponding capacitor Cd(q) becomes effective. The capacitance value of the capacitance variable capacitor part 22C is determined in accordance with the combination of the busbar among the busbars TBC(1) to TBC(Q).

In the surge voltage generation circuit 20B as shown in FIG. 4 or the surge voltage generation circuit 20C as shown in FIG. 5, the resistance value of the variable resistance part 23B or 23C, the inductance of the variable inductor part 24B or 24C, and the capacitance value of the capacitance variable capacitor part 22B or 22C can be varied gradually. In the case where fine-tuning of the drive voltage waveform is not required, or in the case where a specific drive voltage waveform is used for testing, the surge voltage generation circuits 20B, 20C may be adopted. Compared with the surge voltage generation circuit 20A, the surge voltage generation circuits 20B, 20C have simpler configurations, are easier to set and operate, and are highly practical. Additionally, according to the surge voltage generation circuit 20B, it is possible to automatically control the resistance value, the inductance, and the capacitance value.

According to the above, the mutual combinations of the variable resistance parts 23A to 23C, the variable inductor parts 24A to 24C, and the capacitance variable capacitor parts 22A to 22C are not limited to the above examples. For example, the variable resistance part 23A, the variable inductor part 24B, and the capacitance variable capacitor part 22C may be combined, or other components may be combined.

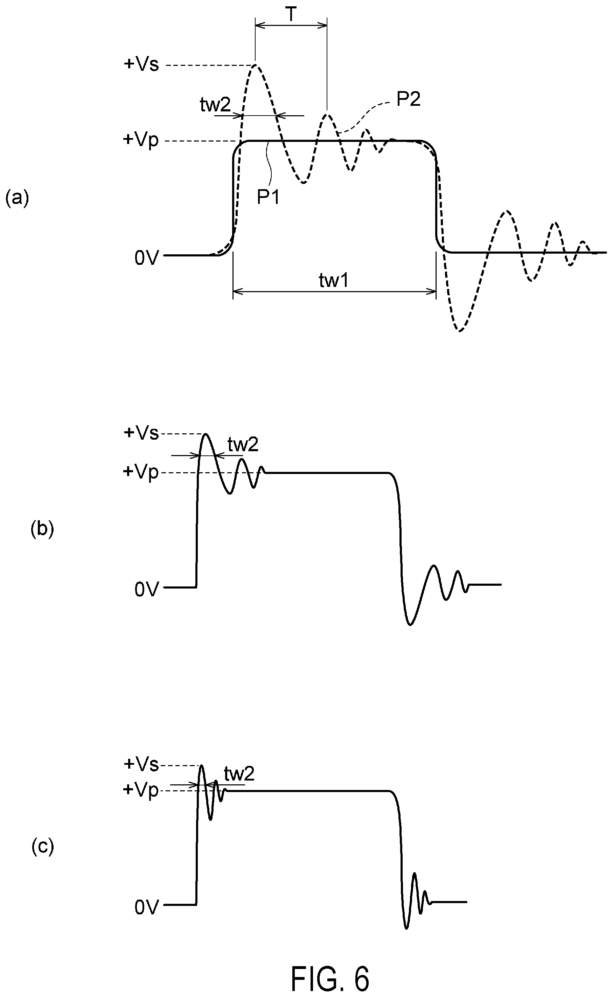

(a), (b), and (c) of FIG. 6 are diagrams schematically illustrating a voltage pulse of a positive polarity including a surge voltage and output from the surge voltage generation circuit. (a) of FIG. 6 illustrates a voltage pulse waveform when the resistance value R of the variable resistance part 23A (23B or 23C) is sufficiently smaller than the square root of the ratio (L/Cc) between a combined capacitance Cc of the capacitance value C of the capacitance variable capacitor part 22A (22B or 22C) and a floating electrostatic capacitance of the test object M and the inductance L of the variable inductor part 24A (24B or 24C), that is, when:
[Formula 1]

$$R <<< \sqrt{\frac{L}{Cc}} \quad \cdots (1)$$

(b) of FIG. 6 illustrates a voltage pulse waveform when the resistance value R is smaller than the square root of the ratio (L/Cc) and greater than the case of (a) of FIG. 6, that is:
[Formula 2]

$$R << \sqrt{\frac{L}{Cc}} \quad \cdots (2)$$

(c) of FIG. 6 illustrates a voltage pulse waveform when the resistance value R is equal to or less than the square root of the ratio (L/Cc) and greater than the case of (b) of FIG. 6, that is:
[Formula 3]

$$R \leq \sqrt{\frac{L}{Cc}} \quad \cdots (3)$$

(a) of FIG. 6 illustrates that a voltage pulse P1 output from the pulse generation circuit 10 and a voltage pulse P2 including a surge voltage output from the surge voltage generation circuit 20 are overlapped. The voltage pulse P1 of the positive polarity has a square waveform, and is formed when the semiconductor switch HVS1 is turned on/off once.

The amplitude of the voltage pulse P1, that is, a peak voltage +Vp, is freely adjustable by using a setting voltage of the positive DC power source V1. A time width tw1 of the voltage pulse P1 is freely adjustable by using the on-time of the semiconductor switch HVS1. Similarly, the amplitude of the negative voltage pulse, that is, a peak voltage, is freely adjustable by using a setting voltage of the negative DC power source S2. A time width of the negative voltage pulse is freely adjustable by using the on-time of the semiconductor switch HVS2. A wave crest value Vs and a half width tw2 of the surge voltage included in the voltage pulse P2 are determined by using the inductance L and the combined capacitance Cc. An oscillation period T of the surge voltage is as represented in Formula ((4) below.
[Formula 4]

$$T = \sqrt{L \cdot Cc} \quad \cdots (4)$$

As shown in FIG. 6, the smaller the resistance value R, the greater the wave crest value Vs and the half width tw2 of the surge voltage. In addition, the smaller the resistance value R, the greater the number of times of oscillation of the surge voltage.

As described above, by adjusting the resistance value R, the inductance L, and the combined capacitance Cc, the wave crest value, the half width, and the number of times of oscillation of the surge voltage can be freely set. In addition, by adjusting the setting voltage of the positive DC power source V1 (or the negative DC power source V2) and the on-time of the semiconductor switch HSV1 (or the semiconductor switch HVS2), the amplitude and the time width of the voltage pulse (fundamental wave) output from the pulse generation circuit 10 can be set freely. Accordingly, the test device 1 of the embodiment is able to completely simulate the actual surge voltage oscillation waveform that actually occurs in the inverter drive motor.

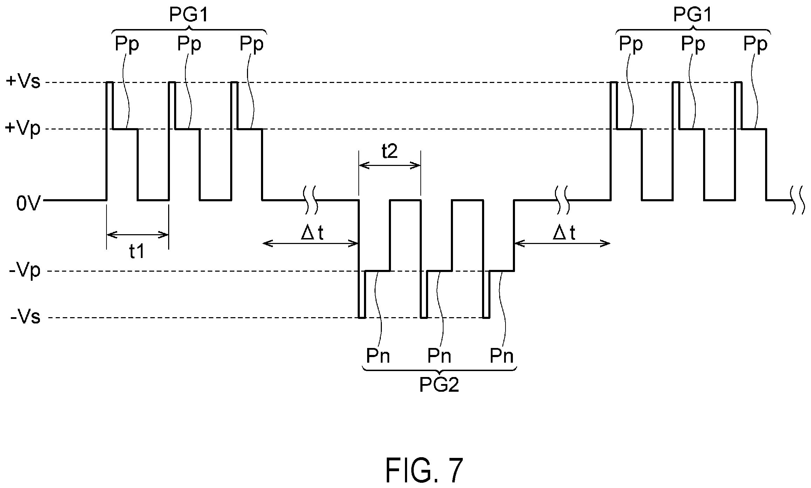

FIG. 7 is a schematic diagram illustrating an example of a drive voltage waveform of two polarities including the surge voltage. In the example, a first pulse group PG1 formed by multiple positive voltage pulses Pp including the surge voltage and a second pulse group PG2 formed by multiple negative voltage pulses Pn including the surge voltage are alternately output from the surge voltage generation circuit 20 at a time interval (dead time) Δt. In the example, the positive voltage pulse Pp and the negative voltage pulse Pn are output in bursts within a period set in advance, respectively. In the first pulse group PG1, a repeating period t1 of the voltage pulse Pp is constant. In the second pulse group PG2, a repeating period t2 of the voltage pulse Pn is constant.

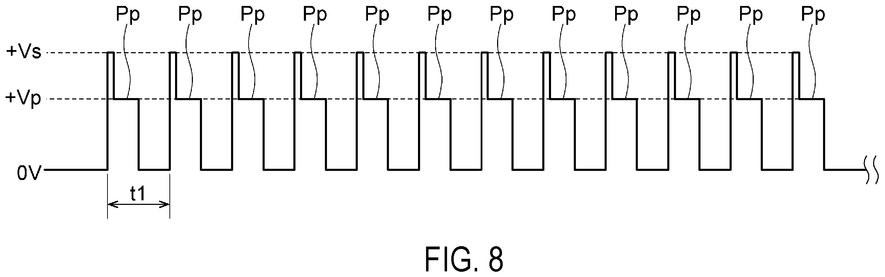

FIG. 8 is a schematic diagram illustrating an example of a drive voltage waveform including the surge voltage. In the example, the positive voltage pulse Pp including the surge voltage is output permanently (continuously) from the surge voltage generation circuit 20 until the test ends. The repeating period t1 of the voltage pulse Pp is constant.

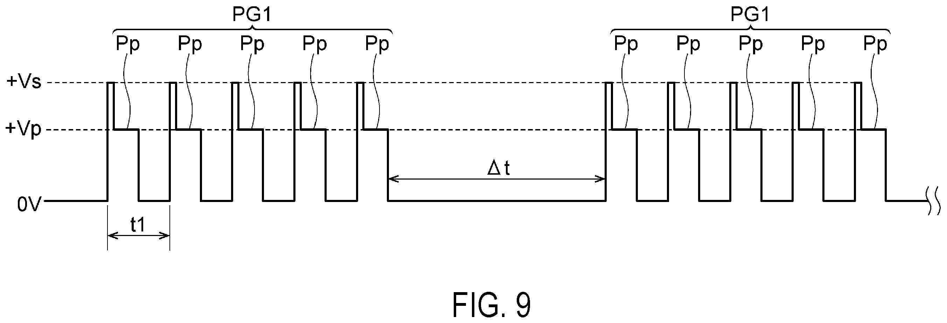

FIG. 9 is a schematic diagram illustrating an example of a drive voltage waveform including the surge voltage. In the example, multiple first pulse groups PG1 formed by multiple voltage pulses Pp including the surge voltage are output from the surge voltage generation circuit 20 at a time interval Δ therebetween. In the example, the positive voltage pulse Pp is output in bursts within a period set in advance. In the first pulse group PG1, a repeating period t1 of the voltage pulse Pp is constant.

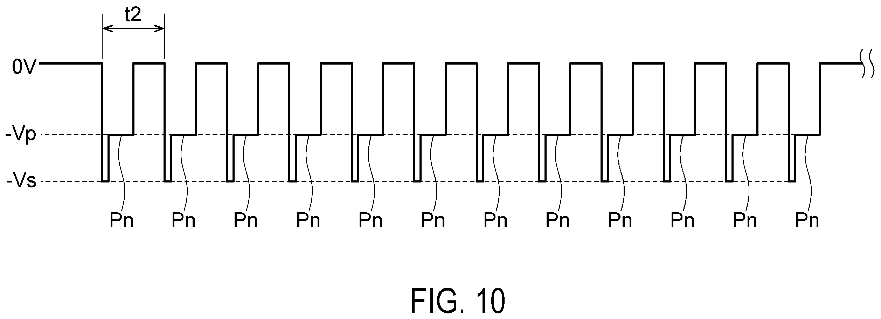

FIG. 10 is a schematic diagram illustrating an example of a drive voltage waveform including the surge voltage. In the example, the negative voltage pulse Pp including the surge voltage is output permanently (continuously) from the surge voltage generation circuit 20 until the test ends. The repeating period t2 of the voltage pulse Pn is constant.

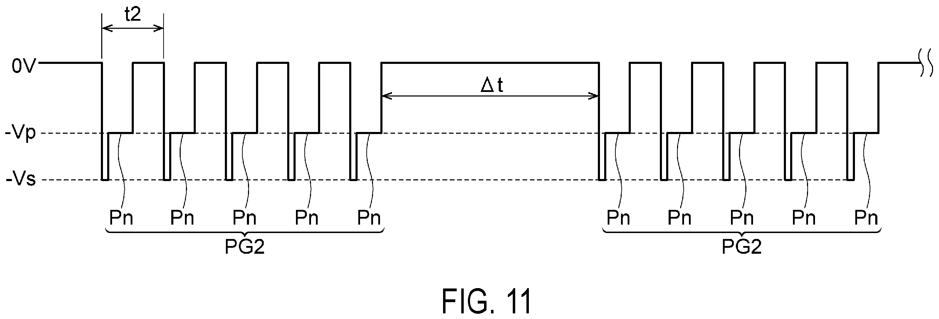

FIG. 11 is a schematic diagram illustrating an example of a drive voltage waveform including the surge voltage. In the example, multiple second pulse groups PG2 formed by multiple voltage pulses Pp including the surge voltage are output from the surge voltage generation circuit 20 at a time interval Δt therebetween. In the example, the negative voltage pulse Pp is output in bursts within a period set in advance. In the second pulse group PG2, a repeating period t2 of the voltage pulse Pn is constant.

FIG. 12 is a schematic diagram illustrating an example of a drive voltage waveform without a surge voltage. In the example, a single positive voltage pulse Pp not including a surge voltage and a single negative voltage pulse Pn not including a surge voltage are alternately output from the surge voltage generation circuit 20 at a time interval Δt therebetween. Such drive voltage waveform without a surge voltage is realized by forming a non-inductive circuit by short-circuiting an inductor in the surge voltage generation circuit 20. That is, in the surge voltage generation circuit 20A shown in FIG. 3, the slider 24b of the variable inductor part 24A is moved to a position that bypasses the inductor 24a. In the surge voltage generation circuit 20B shown in FIG. 4, only the switch YL(0) is turned on, among the switches YL(0) to YL(M). In the surge voltage generation circuit 20C shown in FIG. 5, an end of the busbar TBL is connected to the terminal AL(0). The time when the voltage pulse Pp rises and falls and the time when the voltage pulse Pn rises and falls are adjusted according to the resistance value of the variable resistance part 23A, 23B, or 23C. In the figure, the case where the rise and the fall are steep is overlapped with the case where the rise and the fall are gradual.

FIG. 13 is a schematic diagram illustrating an example of a drive voltage waveform without a surge voltage. In the example, the single positive voltage pulse Pp not including a surge voltage and the single negative voltage pulse Pn not including a surge voltage are alternately output from the surge voltage generation circuit 20 without a time interval. Such drive voltage waveform without a surge voltage, like the drive voltage waveform shown in FIG12 is realized by forming a non-inductive circuit by short-circuiting an inductor in the surge voltage generation circuit 20. The time width of the voltage pulse Pp and the time width of the voltage pulse Pn are set to be equal, and the absolute value of the peak voltage +Vp of the voltage pulse PP and the absolute value of the peak voltage -Vp of the voltage pulse Pn are equal. Accordingly, a drive voltage waveform having a duty of 50% and symmetrical in terms of positivity (positive/negative) is obtained. The time when the voltage pulse Pp rises and falls and the time when the voltage pulse Pn rises and falls are adjusted according to the resistance value of the variable resistance part 23A, 23B, or 23C. In the figure, the case where the rise and the fall are steep is overlapped with the case where the rise and the fall are gradual.

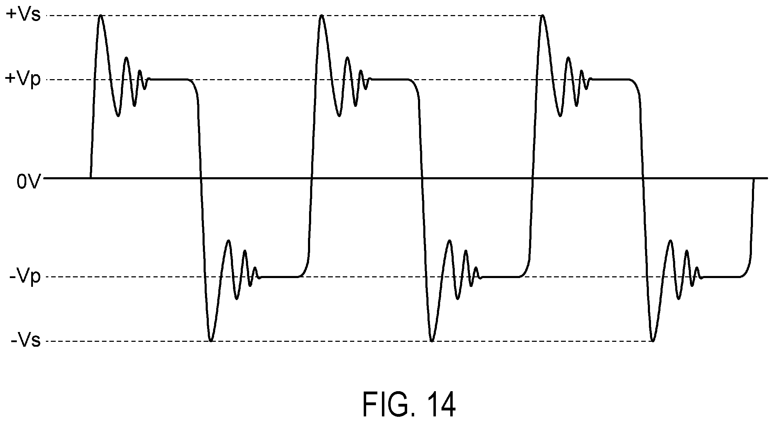

As shown in FIGs. 12 and 13, a drive voltage waveform without the surge voltage can be used for comparison with a drive voltage waveform having the surge voltage (see FIG. 14, for example) in terms of the insulation properties and the service time of the test object M.

In FIGs. 7 to 13, the absolute value of the wave crest value Vs of the surge voltage is, for example, 3 kVp or more and 20 kVp or less. In an embodiment, the absolute values of the wave crest value Vs of the surge voltage are set to 3 kVp, 6 kVp, 10 kVp, and 20 kVp. The settable range of the frequencies (reciprocals of the repeating periods t1 and t2) of the voltage pulses Pp and Pn is, for example, 1k to 100 kHz. The settable range of the rising times and the fall times of the voltage pulses Pp and Pn are, for example, 20 ns to 100 ns.

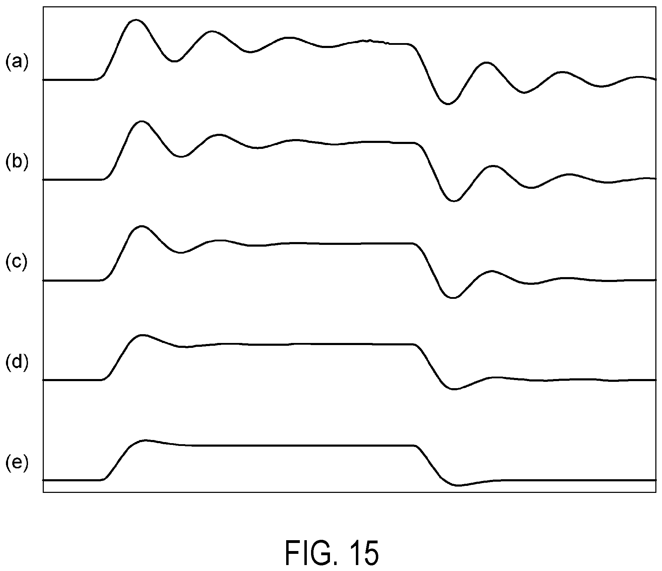

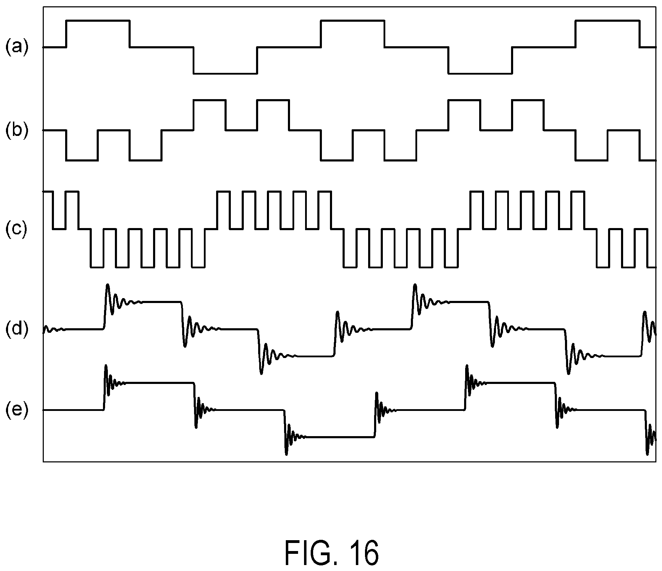

(a) to (e) of FIG. 15 and FIG. 16 are diagrams illustrating drive voltage waveforms including the surge voltage, which are actually tested in a test device. (a) to (e) of FIG. 15 illustrate a single positive voltage pulse Pp including the surge voltage. (a), (d), and (e) of FIG. 16 illustrate the case where the positive voltage pulse Pp and the negative voltage pulse Pn are alternately output. In (b) and (c) of FIG. 16, the case where the first pulse group PG1 formed by multiple positive voltages PP and the second pulse group PG2 formed by multiple negative voltage pulses Pn are output alternately at a time interval (see FIG. 7 for example). (a), (b), and (c) of FIG. 16 illustrate a drive waveform without the surge voltage. (d) and (e) of FIG. 16 are drive voltage waveforms including a surge voltage.

FIG. 17 is a block diagram illustrating a system configuration example of the test device 1 according to the embodiment. As shown in FIG. 17, in addition to the above configuration, the test device 1 includes an integrated interface 51, a computer 52, a display part 53, a printer 54, an input operation part 55, a low voltage power source 56, a partial discharge measurement device 57, and a thermostatic chamber 58 for accommodating the test object M.

The low voltage power source 56 provides a power source voltage to the semiconductor switches HVS1 to HVS3 and a control element. The low voltage power source 56, the positive DC power source V1 and the negative DC power source V2 form the power source part of the pulse generation circuit 10.

The integrated interface 51 is electrically connected to the computer 52. A group formed by the integrated interface 51 and the computer 52 serve as the first control part and the second control part of the embodiment. The integrated interface 51 is connected to the semiconductor switches HVS1 to HVS3 via optical fibers. The computer 52 provides respective optical trigger signals LT1 to LT3 to the respective semiconductor switches HVS1 to HVS3 via the integrated interface 51. The computer 52 forms the drive voltage waveform through controlling the on/off timing of the semiconductor switches HVS1 to HVS3 by using the optical trigger signals LT1 to LT3. The time width of the positive voltage pulse is equal to the time width of the optical trigger signal LT1 to the semiconductor switch HVS1. The time width of the negative voltage pulse is equal to the time width of the optical trigger signal LT2 to the semiconductor switch HVS2.

The integrated interface 51 is electrically connected to the positive DC power source V1, the negative DC power source V2, the variable resistance part 23A, 23B, or 23C, the variable inductor part 24A, 24B, or 24C, the capacitance variable capacitor 22A, 22B, or 22C, the current sensor 41, the high voltage probe 42, the partial discharge measurement device 57, and the thermostatic chamber 58. The computer 52 outputs, through the integrated interface 51, a control signal to the positive DC power source V1, the negative DC power source V2, the variable resistance part 23A, 23B, or 23C, the variable inductor part 24A, 24B, or 24C, and the capacitance variable capacitor 22A, 22B, or 22C respectively. The computer 52 controls the voltage values of the positive DC power source V1 and the negative DC power source V2 by using the control signal. The computer 52 controls the resistance values of the variable resistance parts 23A, 23B, or 23C by using the control signal. The computer 52 controls the inductance of the variable inductor part 24A, 24B, or 24C by using the control signal. The computer 52 controls the capacitance value of the capacitance variable capacitor part 22A, 22B, or 22C by using the control signal. The computer 52 controls the temperature of the thermostatic chamber 58 by using the control signal, and receives signals indicating the temperature in the thermostatic chamber 58 and collects and records temperature data.

The computer 52 can detect the magnitude of the current output from the surge voltage generation circuit 20 by using signals from the current sensor 51. The computer 52 can detect the magnitude of the voltage output from the surge voltage generation circuit 20 by using signals from the high voltage probe 42. As shown in FIG. 15, each of the output signal of the current sensor 41 and the output signal of the high voltage probe 42 is split into two, one of the two signals may be transmitted to the integrated interface 51 and used for over-current protection in the computer 52 and for data collection and recording. In addition, the other of the signals is transmitted to the oscilloscope 43 and display the drive voltage waveform and the current output waveform output from the surge voltage generation circuit 20 on the oscilloscope 43 in real-time. In the case where the output signal from the current sensor 41 exceeds the value set in advance by the operator due to a dielectric breakdown or a ground fault of the test object M, the computer 52 quickly cuts off the semiconductor switches HVS1 to HVS3 in operation, and simultaneously cuts off the positive DC power source V1 and negative DC power source V2 in real time. In addition, the computer 52 notifies, through the display part 53, that the test object M has abnormality.

The computer 52 can detect the magnitude of the partial discharge generated in the test object M through the signal from the partial discharge measurement device 57. Based on the signal from the partial discharge measurement device 57, the computer 52 determines whether a partial discharge occurs, detects the partial discharge start voltage, and analyzes the intensity of the partial discharge, etc. As the partial discharge measurement device 57, a partial discharge detector (model No. NPD-1) manufactured by Nissin Pulse Electronics Co., Ltd. is used. The partial discharge detector is able to measure a frequency band wider than the conventional partial discharge detector and perform measurement accurately even for a partial discharge charge amount of a few picocoulombs (pCs).

The display part 53, the printer 54, and the input operation part 55 are electrically connected with the computer 52. The computer 52 displays test results on the display part 53. The computer 52 prints test results using the printer 54. The display part 53 and the printer 54 are used for data processing of the test results, recording of the test results, and preparation of reports. The display part 53 may also display the operational state of the test device 1.

The input operation part 55 receives the input of a setting parameter and the input of an execution command from the operator. The setting parameter received by the input operation part 55 is displayed on the display part 53. The input operation part 55 may be a keyboard connected with a computer as the computer 52, and may also be a touch panel provided on the display part 53.

In the setting parameter received by the input operation part 55, the intermittent voltage pulses included in the drive voltage waveform may include the information relating to only the positive voltage pulse Pp as shown in FIG. 8 or FIG. 9, only include the negative voltage pulse Pn as shown in FIGs. 10 or 11, or both of the voltage pulses Pp, Pn as shown in FIGs. 7, 12, and 13. The setting parameter may also include whether the intermittent voltage pulses included in the drive voltage waveform are permanently output until the test ends as shown in FIGs. 8 or 10 or the intermittent voltage pulses are output in bursts within a period set in advance as shown in FIGs. 7, 9, and 11. The setting parameter may also include information relating to the amplitude of the voltage pulse included in the drive voltage waveform, that is, information relating to the peak voltages +Vp, -Vp of the voltage pulses Pp, Pn. The setting parameter may also include information relating to the frequencies (1/t1 or 1/t2) of the intermittent voltage pulses Pp, Pn included in the drive voltage waveform. The setting parameter may also include information relating to the time width tw1 of the intermittent voltage pulses Pp, Pn included in the drive voltage waveform. The setting parameter may also include at least one or all of a group consisting of the time interval Δt, the power source voltage +Hv of the positive DC power source V1, the power source voltage -HV of the negative DC power source V2, the resistance value R of the variable resistance part 23A (23B, or 23C), the inductance L of the variable inductor part 24A (24B, or 24C), and the capacitance value C of the capacitance variable capacitor 22A (22B, or 22C). The input operation part 55 provides the setting parameter input through the input operation to the computer 52.

In addition, the input operation part 55 receives an input operation relating to the number of the intermittent voltage pulses (repetition number) included in the drive voltage waveform output from the pulse generation circuit 10, that is, the number of each of the voltage pulses Pp and Pn included in each of the first pulse group PG1 and the second pulse group PG2. The input operation part 55 provides the information relating to the number of the intermittent voltage pulses input through the input operation to the computer 52.

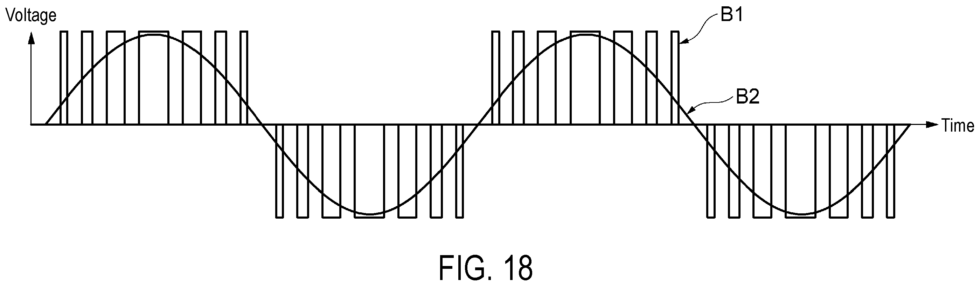

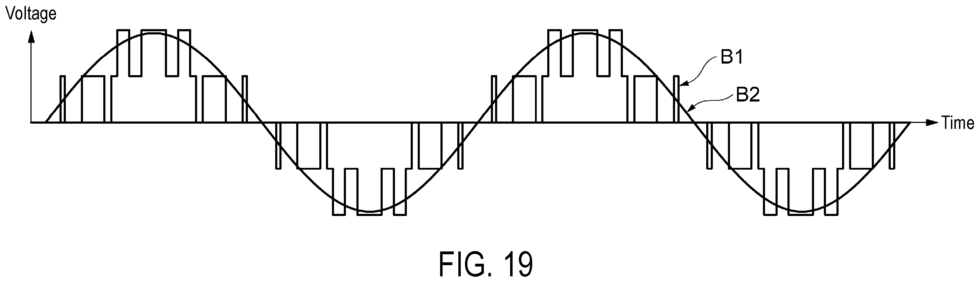

The effects obtained by the test device 1 of the embodiment described above will be described together with the issues associated with the conventional technology. Conventionally, in order to perform the control of each phase of an electric motor, PWM control methods are widely adopted. FIG. 18 is a diagram illustrating an example of a two-level PWM drive waveform. FIG. 19 is a diagram illustrating an example of a three-level PWM drive waveform. In the figures, the vertical axis represents voltage, and the horizontal axis represents time. In the figure, a PWM output waveform B1 as a rectangular wave and an output waveform B2 after the PWM output waveform B1 passes through an LC filter are overlapped and displayed. The output waveform B2 is a sine wave.

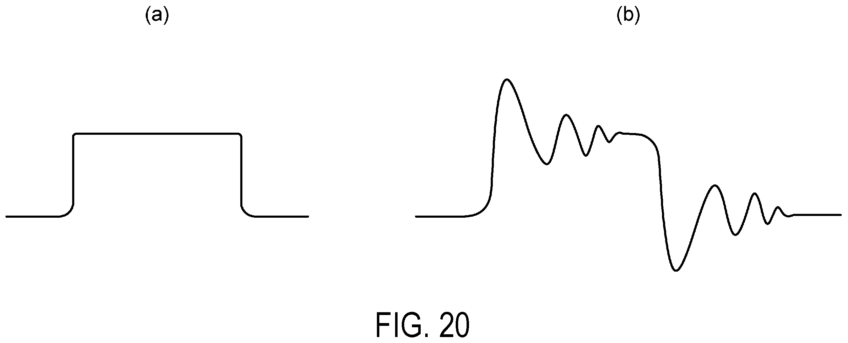

In PWM control, the PWM output waveform B1 is formed through a high-speed switching operation of a semiconductor switch. However, in the rise and the fall of the rectangular wave included in the PWM output waveform B1, a significant surge voltage occurs due to the wiring inductance until the electric motor. (a) of FIG. 20 schematically illustrates a rectangular wave before the surge voltage occurs. (b) of FIG. 20 schematically illustrates a rectangular wave after the surge voltage occurs. As the peak value of the surge voltage entering the electric motor increases, partial discharge occurs in the coating resin of the windings, and the insulation of the electric motor and the windings deteriorates.

While the mechanism with which the insulation deterioration occurs due to the partial discharge resulting from the surge voltage is known, the relative relationship between the partial discharge inception voltage (PDIV) and the discharge charge amount has not been quantitatively evaluated. Regarding the partial discharge with respect to the PWM output waveform in which the pulse group formed by multiple positive voltage pulses and the pulse group formed by multiple negative voltage pulses are alternately repeated, such partial discharge has not been quantitatively evaluated, either. Moreover, a test device capable of performing insulation evaluation when the partial discharge, which is a precursor phenomenon of dielectric breakdown of the electric motor due to surge voltage, the service time evaluation through repeated operation, and a V-t acceleration deterioration test is not conventionally present.

With respect to the issue, in the test device 1 of the embodiment, a PWM output waveform can be simulated by using the pulse generation circuit 10, and a surge voltage can be applied to the simulated output waveform by using the surge voltage generation circuit 20. In addition, since the resistance value, the inductance, and the capacitance value of the CLR resonance circuit of the surge voltage generation circuit 20 are variable, the peak value, the half width, and the number of times of oscillation of the surge voltage can be freely set. Therefore, the surge voltage occurring in actual PWM control can be accurately simulated, and the insulation evaluation with respect to partial discharge, the service time evaluation through repeated operation, and the V-t acceleration deterioration test, etc., can be accurately performed. Moreover, the quantitative evaluation for the relative relationship between PDIV and the discharge charge amount, as well as the quantitative evaluation for the partial discharge with respect to the PWM output waveform in which the pulse group formed by multiple positive voltage pulses and the pulse group formed by multiple negative voltage pulses are alternately repeated can be accurately performed.

The configuration of the test device 1 of the embodiment is such that the operating functions are all separated into units, and each unit is equipped with a wide range of fault detection functions, and can automatically notify the operator of the occurrence of a fault via the display part 53, etc. In the case where repair is required, the broken unit can be easily replaced as a whole, and recovery work can be quickly performed by anyone even other than the manufacturer of the test device 1.

According to the embodiment, the pulse generation circuit 10 may also have the semiconductor switch HVS1, the semiconductor switch HVS2, the bridge full-wave rectifier BR1, the semiconductor switch HVS3. A circuit that speeds up the time of the fall of the positive and negative voltage pulses and quickly returns these voltage pulse to the reference potential is also called a ground (GND) circuit, in light of its function. Normally, to set the falling potentials of the positive and negative voltage pulses as the reference potential, two semiconductor switches are required: one corresponding to the positive voltage pulse and the other corresponding to the negative voltage pulse. However, in the embodiment, by using the bridge full-wave rectifier BR1, the ground circuit is formed by only one semiconductor switch HVS3. Accordingly, the circuit configuration can be simplified. The pulse generating circuit 10 can output a voltage having a two-level or three-level inverter drive waveform as a drive voltage waveform.

According to the configuration, the pulse generation circuit 10 may have the semiconductor switches HVS1 to HVS3 for forming the drive voltage waveform and the integrated interface 51 and the computer 52 for generating the optical trigger signals LT1 to LT3 respectively controlling the semiconductor switches HVS1 to HVS3. The integrated interface 51 may then provide the optical trigger signals LT1-LT3 to the semiconductor switches HVS1-HVS3, respectively. By providing the optical trigger signals LT1 to LT3 to the semiconductor switches HVS1 to HVS3, respectively, the influence of noise can be reduced and malfunctions can be prevented.

According to the embodiment, the input operation part 55 may also receive an input operation relating to the number of the voltage pulses PP included in the first pulse group PG1 and/or the number of the voltage pulses Pn included in the second pulse group PG2 and provide information relating to the numbers of the voltage pulses Pp, Pn input through the input operation. Then, the computer 52 may also determine the number of the voltage pulses Pp included in the first pulse group PG1 and/or the number of the voltage pulses Pn included in the second pulse group PG2 according to the information. In such case, the number of the voltage pulses Pp included in the first pulse group PG1 and/or the number of the voltage pulses Pn included in the second pulse group PG2 can be freely and easily set.

According to the embodiment, the input operation part 55 may receive the input operation relating to the drive voltage waveform, provide the information relating to the drive voltage waveform input through the input operation to the computer 52, and determine the drive voltage waveform according to the information. The information relating to the drive voltage waveform may also include at least one of: the information relating to whether the intermittent pulses are formed by positive pulses only, negative pulses only, or both of the positive pulses and the negative pulses; the information relating to whether the intermittent pulses are permanently output until the test ends or output in bursts within a period set in advance; the information relating to the amplitude of the intermittent pulse; the information relating to the frequency of the intermittent pulses; and the information relating to the time width of each pulse forming the intermittent pulses. In such case, since the drive voltage waveform can be easily configured, the test device can be set freely.

The inverter pulse insulation test device according to the disclosure is not limited to the embodiments, and various modifications are possible. For example, in the embodiment, the variable non-inductive resistor is used as the variable resistance part of the surge voltage generation circuit. However, the type of the resistor used in the variable resistance part is not limited thereto. For example, an electronic control type equivalent variable resistor may also be used.

[Reference Signs List]

1: Inverter pulse insulation test device; 10: Pulse generation circuit; 10b: Output end (first output end); 11, 12: High voltage terminal; 13: Output terminal; 20, 20A, 20B, 20C: Surge voltage generation circuit; 20a: Input end; 20b: Output end (second output end); 21A, 21B, 21C: Serial circuit; 22A, 22B, 22C: Capacitance variable capacitor; 23A, 23B, 23C: Variable resistance part; 23a: Resistor; 23b: Slider; 24A, 24B, 24C: Variable inductor part; 24a: Inductor; 24b: Slider; 41: Current sensor; 42: High voltage probe; 43: Oscilloscope; 51: Integrated interface; 52: Computer; 53: Display unit; 54: Printer; 55: Input operation part; 56: Low voltage power source; 57: Partial discharge measurement device; 58: Thermostatic chamber; ATB, AL(0) to AL(M): Terminal; BR1: Bridge full-wave rectifier; C1, C2: Capacitor; Cd(1) to Cd(Q): Capacitor; GND: Reference potential line; HSV1: Semiconductor switch (first semiconductor switch); HSV2: Semiconductor switch (second semiconductor switch); HSV3: Semiconductor switch (third semiconductor switch); L(1) to L(Q): Inductor; LT1 to LT3: Optical trigger signal; M: Test object; M1, M2, M3: Motor; N1, N2, N3, N4: Node; P1, P2: Voltage pulse; PG1: First pulse group; PG2: Second pulse group; Pn, Pp: Voltage pulse; R(1) to R(N): Resistor; Rd1, Rd2: Discharge resistor; Rp1, Rp2, Rs1, Rs2, Rs3: Resistor; TBL, TB(1) to TB(N), TBC(1) to TBC(Q): Busbar; V1: Positive DC power source; V2: Negative DC power source; YC(1) to YC(Q), YL(0) to YL(M), YR(0) to YR(N): Switch.

**Claims**

1. An inverter pulse insulation test device, comprising:

   a pulse generation circuit, having a first output end, and outputting, from the first output end, a voltage having a simulated drive voltage waveform comprising intermittent pulses; and
   a surge voltage generation circuit, having an input end electrically connected to the first output end of the pulse generation circuit and a second output end connected to a test object, changing the drive voltage waveform by generating a surge voltage at a rise and a fall of each pulse of the drive voltage waveform input from the input end, and outputting, from the second output end, a voltage having the drive voltage wave form that is changed,
   wherein the surge voltage generation circuit comprises:
   a variable resistor and a variable inductor connected in series with each other; and
   a capacitance variable capacitor,
   an end of a serial circuit of the variable resistor and the variable inductor form the input end of the surge voltage generation circuit,

an other end of the serial circuit is connected to the second output end of the surge voltage generation circuit,
an end of the capacitance variable capacitor is connected to a node between the other end of the serial circuit and the second output end, and an other end of the capacitance variable capacitor is connected to a constant potential line.

2. The inverter pulse insulation test device as claimed in claim 1, wherein the pulse generation circuit outputs a voltage having a two-level or three-level inverter drive waveform as the drive voltage waveform, and
   the pulse generation circuit comprises:

   a first semiconductor switch, wherein an end is connected to a positive voltage terminal, and an other end is connected to the first output end;
   a second semiconductor switch, wherein an end is connected to a negative voltage terminal, and an other end is connected to the first output end;
   a bridge full-wave rectifier, having two input ends and two output ends, wherein one of the two input ends is connected to a reference potential line, and one of the two output ends is connected to the first output end; and
   a third semiconductor switch, wherein an end is connected to an other one of the input ends of the bridge full-wave rectifier and an other end is connected to an other one of the output ends of the bridge full-wave rectifier.

3. The inverter pulse insulation test device as claimed in claim 1, wherein the pulse generation circuit has: a plurality of semiconductor switches for forming the drive voltage waveform; and

   a first control part, generating a plurality of optical trigger signals respectively controlling the semiconductor switches, and
   the first control part provides the respective optical trigger signals to the respective semiconductor switches.

4. The inverter pulse insulation test device as claimed in any one of claims 1 to 3, further comprising:

   a second control part, controlling the drive voltage waveform in the pulse generation circuit; and
   an input operation part, receiving an input operation relating to a number of the intermittent pulses, and providing information relating to the number of the intermittent pulses input through the input operation to the second control part, wherein the second control part determines the number of the intermittent pulses in accordance with the information.

5. The inverter pulse insulation test device as claimed in any one of claims 1 to 3, further comprising:

a second control part, controlling the drive voltage waveform in the pulse generation circuit; and

an input operation part, receiving an input operation relating to the drive voltage waveform and providing, to the second control part, information relating to the drive voltage waveform input through the input operation,

wherein the second control part determines the drive voltage waveform in accordance with the information, and

the information relating to the drive voltage waveform comprises at least one of:

information relating to whether the intermittent pulses are formed by positive pulses only, negative pulses only, or both of the positive pulses and the negative pulses;

information relating to whether the intermittent pulses are permanently output until a test ends or output in bursts within a period set in advance;

information relating to an amplitude of the intermittent pulses;

information relating to a frequency of the intermittent pulses; and

information relating to a time width of each pulse forming the intermittent pulses.

FIG. 1

FIG. 2

FIG. 3

FIG. 4

FIG. 5

EP 4 589 314 A1

FIG. 6

FIG. 7

EP 4 589 314 A1

EP 4 589 314 A1

FIG. 8

FIG. 9

EP 4 589 314 A1

FIG. 10

FIG. 11

EP 4 589 314 A1

FIG. 12

EP 4 589 314 A1

FIG. 13

FIG. 14

FIG. 15

FIG. 16

FIG. 17

FIG. 18

EP 4 589 314 A1

FIG. 19

EP 4 589 314 A1

(a)

(b)

FIG. 20

EP 4 589 314 A1

## INTERNATIONAL SEARCH REPORT

| International application No. |
| --- |
| **PCT/JP2022/034278** |

| A. | CLASSIFICATION OF SUBJECT MATTER |
| --- | --- |

*G01R 31/34*(2020.01)i; *G01R 31/12*(2020.01)i
FI: G01R31/34 D; G01R31/12 Z

According to International Patent Classification (IPC) or to both national classification and IPC

| B. | FIELDS SEARCHED |
| --- | --- |

Minimum documentation searched (classification system followed by classification symbols)

G01R31/34; G01R31/12; G01R31/50

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | JP 2009-288250 A (HITACHI INDUSTRIAL EQUIPMENT SYSTEMS CO LTD) 10 December 2009 (2009-12-10)<br>    paragraphs [0021]-[0025], fig. 1, 13, 15, 16 | 1, 3-5 |
| A | | 2 |
| Y | JP 2021-189120 A (AISHIN KK) 13 December 2021 (2021-12-13)<br>    paragraphs [0003], [0024], [0025] | 1, 3-5 |
| Y | JP 2013-190342 A (TOSHIBA MITSUBISHI-ELECTRIC INDUSTRIAL SYSTEM CORP) 26 September 2013 (2013-09-26)<br>    paragraphs [0017]-[0072], fig. 1-3 | 4-5 |
| Y | KR 10-1604443 B1 (KOREA ELECTROTECHNOLOGY RESEARCH INSTITUTE) 25 March 2016 (2016-03-25)<br>    paragraph [0009] | 5 |
| A | WO 2014/083866 A1 (MITSUBISHI ELECTRIC CORPORATION) 05 June 2014 (2014-06-05)<br>    paragraphs [0028]-[0035] | 1-5 |

☐ Further documents are listed in the continuation of Box C.    ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **07 November 2022** | **15 November 2022** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT
### Information on patent family members

International application No.

**PCT/JP2022/034278**

| Patent document cited in search report | | | Publication date (day/month/year) | Patent family member(s) | Publication date (day/month/year) |
|---|---|---|---|---|---|
| JP | 2009-288250 | A | 10 December 2009 | (Family: none) | |
| JP | 2021-189120 | A | 13 December 2021 | (Family: none) | |
| JP | 2013-190342 | A | 26 September 2013 | US 2015/0015303 A1 paragraphs [0038]-[0093], fig. 1-3 WO 2013/136793 A1 EP 2827159 A1 CA 2867198 A1 CN 104169730 A KR 10-2014-0138918 A | |
| KR | 10-1604443 | B1 | 25 March 2016 | (Family: none) | |
| WO | 2014/083866 | A1 | 05 June 2014 | US 2015/0247901 A1 paragraphs [0064]-[0077] DE 112013005707 B4 CN 104797949 A | |

Form PCT/ISA/210 (patent family annex) (January 2015)

**REFERENCES CITED IN THE DESCRIPTION**

**Patent documents cited in the description**

- WO 2014083866 A
- WO 2012147163 A
- CN 106226663
- CN 204439681